# FASCICULE DE BREVET EUROPEEN

(11) **EP 1 030 409 B1**
(45) Date de publication et mention de la délivrance du brevet: **12.06.2002**
(21) Numéro de dépôt: 99100742.8
(22) Date de dépôt: 15.01.1999
(51) Int. Cl.: H01R 13/703, H01S 5/02

(54) **Dispositif muni d'au moins une diode laser et ensemble comprenant un tel dispositif et un connecteur à une alimentation électrique**
Vorrichtung, die mindestens eine Laserdiode umfasst, Anordnung mit einer derartigen Vorrichtung und einem Stecker zur elektrischen Stromversorgung
Device having at least a diode laser, assembly comprising such a device and a connector for electrical power supply

(43) Date de publication de la demande: 23.08.2000
(73) Titulaire: LASAG AG, CH-3600 Thun (CH)
(72) Inventeur: Gressly, André, 3626 Hünibach (CH); Frei, Bruno, 3027 Bern (CH)
(74) Mandataire: Ravenel, Thierry Gérard Louis

(56) Documents cités:
- EP-A- 0 661 912
- GB-A- 1 197 299
- US-A- 4 438 303
- PATENT ABSTRACTS OF JAPAN vol. 018, no. 641 (E-1639), 6 décembre 1994 -& JP 06 251830 A (MATSUSHITA ELECTRIC IND CO LTD), 9 septembre 1994

## Description

La présente invention concerne le domaine des dispositifs munis d'au moins une diode laser et les installations ou ensembles comprenant un tel dispositif avec un connecteur à une alimentation électrique destinée au dispositif muni d'au moins une diode laser.

Une diode laser est sensible à la polarité d'une tension d'alimentation ou de toute autre tension appliquée entre l'anode et la cathode de cette diode laser ou d'un dispositif muni d'au moins une diode laser qui est alimentée par cette anode et cette cathode. En effet, si une tension de fausse polarité dépassant le seuil de claquage de la diode laser est appliquée à celle-ci, cette tension détériore généralement la diode laser de manière irréversible. Ainsi, il est important de protéger les diodes laser et tout dispositif intégrant de telles diodes laser contre l'application de tension de fausse polarité dépassant notamment le seuil de claquage de ces diodes laser et en particulier contre des décharges électriques pouvant survenir lors de manipulations de ces diodes laser ou de dispositifs les comprenant tant qu'elles ne sont pas associées à une alimentation électrique appropriée au moyen d'un connecteur prévu à cet effet.

Le but de la présente invention est de prévoir un système de protection électrique pour des dispositif munis d'au moins une diode laser et présentant des organes de connexion à une alimentation électrique destinée à un tel dispositif.

A cet effet, la présente invention concerne un dispositif muni d'au moins une diode laser et de deux organes de connexion électrique à une alimentation électrique pour alimenter ladite au moins une diode laser, caractérisé en ce qu'il comprend deux éléments élastiquement déformables ou déplaçables qui sont électriquement conducteurs et agencés dans une partie du dispositif isolée électriquement des deux organes de connexion, ces deux éléments élastiquement déformables ou déplaçables étant reliés électriquement et agencés de manière à s'appuyer contre deux surfaces de contact respectives des deux organes de connexion lorsque le dispositif n'est pas connecté à ladite alimentation au moyen d'un connecteur externe qui est complémentaire des deux organes de connexion électrique. Lesdits deux éléments élastiquement déformables ou déplaçables sont respectivement séparés des deux organes de connexion lors de l'introduction de ce connecteur externe relié à ladite alimentation ou sont susceptibles d'être respectivement séparés de ces deux organes de connexion après l'introduction de ce connecteur externe.

Il résulte des caractéristiques du dispositif selon l'invention mentionnée ci-dessus que les deux organes de connexion du dispositif, à savoir l'anode et la cathode de ce dispositif sont protégés par un court-circuit établi entre ces deux organes au moyen des éléments élastiquement déformables ou déplaçables qui sont conducteurs et reliés électriquement entre eux. On a ainsi une protection efficace de toutes diodes laser comprises dans le dispositif selon l'invention contre l'application accidentelle d'une tension de fausse polarité et des décharges électriques lors de manipulations du dispositif avant qu'il soit assemblé avec le connecteur externe.

L'invention concerne également un ensemble ou dispositif comprenant un dispositif muni d'au moins une diode laser décrit ci-dessus et un connecteur servant à connecter électriquement ce dispositif à une alimentation électrique. Ce connecteur à deux organes complémentaires aux deux organes de connexion dudit dispositif, ces deux organes complémentaires présentant respectivement deux parties isolées électriquement ou formées d'un matériau isolant qui servent de butées exerçant respectivement une pression sur les deux éléments élastiquement déformables ou déplaçables lors de l'assemblage du connecteur avec le dispositif selon l'invention, de manière à comprimer ou déplacer ces deux éléments et à les maintenir séparés des deux organes de connexion du dispositif une fois celui-ci et le connecteur assemblés.

Un tel ensemble peut former un laser, notamment un laser dont le milieu actif est pompé optiquement au moyen de diodes laser. Les diodes laser sont intégrées dans des dispositifs selon l'invention et montés sur l'armature ou enceinte du laser qui comprend un ou plusieurs connecteurs tels que décrits ci-dessus. Ainsi, les dispositifs comprenant les diodes laser sont protégés électriquement jusqu'au moment de leur installation dans le laser, ce qui permet de garantir une entière fonctionnalité du laser obtenu.

La présente invention sera décrite ci-après à l'aide d'un mode de réalisation particulier, donné à titre d'exemple nullement limitatif, cette description étant faite en référence aux dessins ci-annexés dans lesquels :
- La figure 1 représente schématiquement un dispositif selon l'invention et un connecteur externe totalement séparé de celui-ci;
- La figure 2 montre les mêmes éléments que la figure 1 dans une position d'assemblage intermédiaire; et
- La figure 3 montre les mêmes éléments que les figures 1 et 2, mais dans une position d'assemblage final.

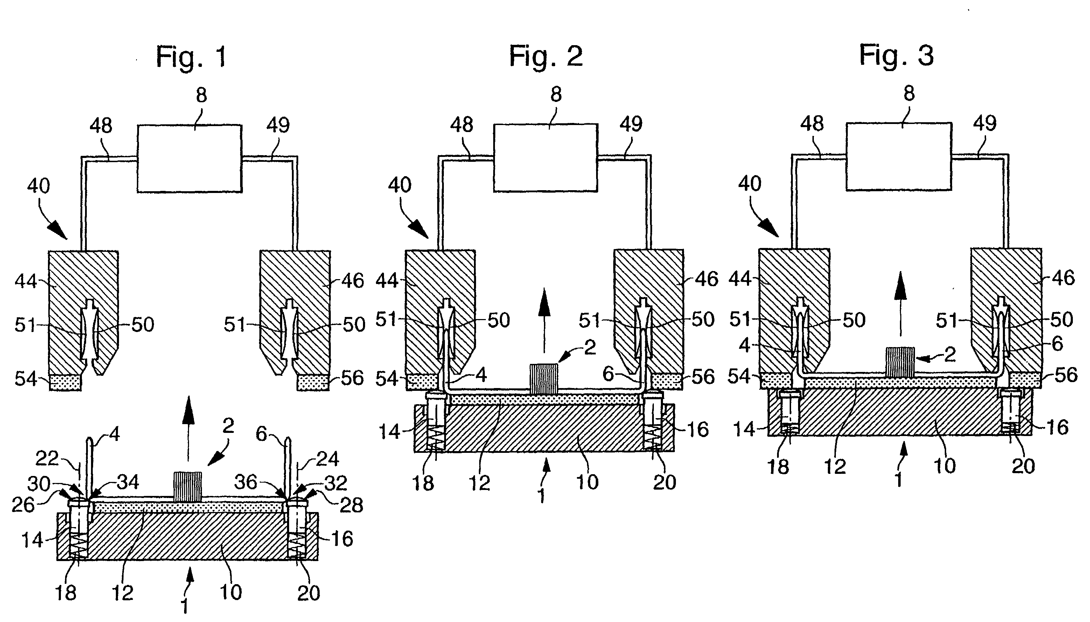

A l'aide des figures 1 à 3, on décrira ci-après un mode de réalisation d'un dispositif muni d'au moins une diode laser selon l'invention et d'un ensemble comprenant un tel dispositif et un connecteur destiné à relier électriquement le dispositif à une alimentation électrique.

Le dispositif 1 comporte une unité d'émission laser 2 formée d'au moins une diode laser et deux organes de connexion électrique 4 et 6 définissant respectivement une cathode et une anode de ce dispositif 1. Les organes 4 et 6 servent de moyen de connexion électrique entre une alimentation électrique externe 8 et l'unité laser 2. L'unité 2 et les organes 4 et 6 sont agencés sur un socle 10 en matériau électriquement conducteur et sont isolés électriquement de ce socle 10 par une couche isolante 12. Les organes de connexion 4 à 6 présentent chacun la forme d'un L.

Selon l'invention, le dispositif comprend également deux pions 14 et 16 formés d'un matériau électriquement conducteur et associés respectivement à deux ressorts 18 et 20 agencés dans le socle 10 pour exercer sur ces pions une force selon les directions longitudinales 22 et 24. Les pions 14 et 16 sont reliés électriquement par le socle 10 et présentent respectivement des têtes 26 et 28. L'homme du métier peut concevoir aisément tout autre moyen de connexion électrique entre les pions 14 et 16. Par exemple, les pions 14 et 16 peuvent être agencés avec les ressorts 18 et 20 dans des tubes métalliques agencés dans un socle quelconque, c'est-à-dire pas nécessairement conducteur. Ces deux tubes peuvent être reliés électriquement par un fil électrique, une plaquette conductrice ou tout autre moyen connu. Les ressorts 18 et 20 peuvent être remplacés par d'autres éléments compressibles.

On notera également qu'à la place des pions 14 et 16 peuvent être prévues de simples goupilles cylindriques ou des blocs ayant un profil transversal quelconque adapté à la fonction des éléments 14 et 16 qui sera décrite ci-après. Ensuite, il est possible de prévoir à la place des pions 14 et 16 associés respectivement aux ressorts 18 et 20 deux éléments élastiquement déformables selon les directions 22 et 24.

Les organes de connexion 4 et 6 présentent chacun dans la région de leur coude 30, respectivement 32 une surface de contact 34, respectivement 36 contre lesquelles s'appuient les têtes 26 et 28 lorsque le dispositif 1 est séparé d'un connecteur qui lui est destiné pour le relier à l'alimentation externe 8, connecteur qui sera décrit ci-après. On remarquera que les têtes 26 et 28 des pions 14 et 16 et les surfaces de contact 34 et 36 peuvent être configurées de manière complémentaire pour que ces surfaces de contact soient suffisamment grandes pour garantir un bon contact électrique entre les pions 14 et 16 et les organes 4 et 6. Ainsi, dans l'état du dispositif 1 tel que représenté à la figure 1, les organes 4 et 6 sont reliés électriquement l'un à l'autre par les pions 14 et 16. En d'autres termes, les pions 14 et 16 engendrent un court-circuit entre l'anode 4 et la cathode 6.

On remarquera que les directions 22 et 24 ne sont pas forcément parallèles entre elle, mais peuvent être légèrement obliques relativement à la direction d'introduction du connecteur externe. On remarquera également que les têtes 26 et 28 s'étendent au-delà des organes 4 et 6. Toutefois, pour les besoins de l'invention, il est seulement nécessaire que les pions 14 et 16 présentent chacun au moins une surface qui ne soit pas couverte par une partie du dispositif 1

Aux figures 1 à 3 est également représenté un connecteur 40 qui comprend deux organes 44 et 46 complémentaires aux organes de connexion 4 et 6 du dispositif 1. Les organes complémentaires 44 et 46 définissent deux organes de contact femelles conformés pour une introduction des deux organes 4 et 6 définissant des organes de contact mâles. Les organes 44 et 46 sont reliés électriquement à une alimentation électrique 8, ce qui est représenté schématiquement sur les figures par deux fils électriques 48 et 49. Chacun des organes 44 et 46 présentent deux lamelles élastiques 50 et 51 agencées de manière à exercer une pression latérale sur les parties des organes mâles 4 et 6 introduites dans les organes femelles 44 et 46 lors de l'assemblage du connecteur 40 au dispositif 1, comme représenté aux figures 2 et 3.

Finalement, les organes 44 et 46 comprennent respectivement deux parties en matériau électriquement isolant 54 et 56 qui sont agencées de manière à venir s'appuyer contre des surfaces d'appui définies par les surfaces externes des têtes 26 et 28 des éléments 14 et 16 lors de l'introduction du dispositif 1 dans le connecteur 40.

Selon l'invention, lors de l'assemblage du connecteur 40 au dispositif 1, les parties 54 et 56 de ce connecteur s'appuient respectivement contre les deux têtes 26 et 28 des éléments élastiquement déplaçables 14 et 16 de manière à les séparer matériellement des organes de connexion 4 et 6, et ainsi séparer électriquement ces organes 4 et 6 des éléments 14 et 16.

A la figure 2 est représentée une position d'introduction intermédiaire du dispositif 1 dans le connecteur 40, cette position intermédiaire correspondant à une position où les blocs 54 et 56 sont en contact avec les têtes 26 et 28 sans déplacement des pions 14 et 16. Dans cette position, le court-circuit entre les organes 4 et 6 est toujours réalisé alors que les parties mâles des organes 4 et 6 sont déjà introduites dans les organes femelles 44 et 46 de manière à établir un contact électrique entre l'unité laser 2 et l'alimentation électrique 8.

En continuant l'introduction du dispositif 1 dans le connecteur 40 jusqu'à la position finale représentée à la figure 3, le connecteur 40 exerce une pression sur les pions 14 et 16 par l'intermédiaire des blocs 54 et 56. Cette pression engendre un déplacement des pions 14 et 16, lesquels sont donc finalement séparés des organes 4 et 6 pour annuler le court-circuit initial entre ces organes 4 et 6.

On remarquera que lors d'un désassemblage du dispositif 1 et du connecteur 40, les pions 14 et 16, qui sont élastiquement déplaçables, se déplacent alors en direction des organes 4 et 6 jusqu'à ce qu'ils soient à nouveau en contact avec ces derniers. Ainsi, l'unité laser 2 est automatiquement protégée contre toute tension appliquée accidentellement au dispositif 1 selon l'invention.

On notera que les parties 54 et 56 pourraient être également formées d'un matériau électriquement conducteur, mais alors ces parties sont isolées électriquement des parties métalliques des organes 44 et 46 qui sont en contact électrique avec les organes de connexion 4 et 6.

On notera également que les lamelles élastiques 50 et 51 peuvent être remplacées par d'autres éléments équivalents assurant un contact électrique correct avec les organes 4 et 6. Par exemple, il est possible de prévoir que les deux branches définies par chacun des organes 44 et 46 soient élastiquement séparables, notamment par un déplacement angulaire. Tout type de connecteur approprié connu de l'homme du métier est envisageable dans le cadre de la présente invention. On peut agencer les organes 44 et 46 de manière que la force latérale exercée sur les organes 4 et 6 engendre une force de frottement statique supérieure à la force exercée par les ressorts 18 et 20 sur les pions 14 et 16. On peut toutefois prévoir des moyens de solidarisation du dispositif 1 et du connecteur 40.

Dans un autre mode de réalisation moins avantageux, les éléments de connexion sont déplaçables, sans toutefois l'être de manière élastique. Dans une première variante, il est nécessaire de les séparer matériellement des organes 4 et 6 par un mécanisme prévu à cet effet une fois que le dispositif 1 et le connecteur 40 ont été assemblés. Dans une autre variante, les pions 14 et 16 sont éloignés des organes 4 et 6 par le connecteur 40, mais basculent dans une position mécaniquement stable dans laquelle ils sont matériellement séparés des organes 4 et 6. On peut prévoir en plus un mécanisme permettant de les ramener dans une position de contact avec les organes 4 et 6. Cette variante s'apparente à un interrupteur présentant 2 niveaux stables ON/OFF, le passage de la position ON à la position OFF étant effectué par le connecteur 40 alors que dans la première variante mentionnée ci-avant, le passage de la position ON à la position OFF est effectué à l'aide d'un mécanisme actionné séparément.

## Revendications

1. Dispositif (1) muni d'au moins une diode laser (2) et de deux organes de connexion (4,6) électrique à une alimentation électrique (8) pour alimenter ladite au moins une diode laser, **caractérisé en ce qu'**il comprend deux éléments (14,16) élastiquement déformables ou déplaçables qui sont électriquement conducteurs et agencés dans une partie (10) du dispositif isolée électriquement des deux organes de connexion, ces deux éléments élastiquement déformables ou déplaçables étant reliés électriquement et agencés de manière à s'appuyer contre deux surfaces de contact respectives (34,36) des deux organes de connexion lorsque le dispositif n'est pas connecté à ladite alimentation au moyen d'un connecteur externe (40) complémentaire des deux organes de connexion électrique, lesdits deux éléments élastiquement déformables ou déplaçables étant respectivement séparés des deux organes de connexion lors de l'introduction de ce connecteur externe ou étant susceptibles d'être respectivement séparés de ces deux organes de connexion après l'introduction de ce connecteur externe.

2. Dispositif selon la revendication 1, **caractérisé en ce que** lesdits deux éléments (14,16) élastiquement déformables ou déplaçables sont élastiquement déformables ou élastiquement déplaçables par l'action d'une pression selon une direction d'introduction dudit connecteur externe (40), ces deux éléments présentant respectivement deux surfaces d'appui (26,28) contre lesquelles peuvent venir s'appuyer respectivement deux parties du connecteur externe lors de l'introduction de celui-ci pour séparer électriquement lesdits deux organes de connexion des deux éléments élastiquement déformables ou élastiquement déplaçables.

3. Dispositif selon la revendication 2, **caractérisé en ce que** chacun desdits deux éléments (14,16) élastiquement déformables ou élastiquement déplaçables est formé par une goupille ou un pion associé(e) à un ressort ou un bloc de matériau compressible permettant un déplacement élastique de chacun de ces deux éléments selon ladite direction d'introduction.

4. Dispositif selon la revendication 2 ou 3, **caractérisé en ce que** chacun des deux organes de connexion (4,6) présentent une forme en L, lesdites deux surfaces de contact (34,36) étant situées respectivement dans les régions des deux coudes (30,32) présentés respectivement par ces deux organes.

5. Ensemble comprenant un dispositif (1) selon l'une des revendications 2 à 4 et un connecteur (40) distinct de ce dispositif qui sert à connecter électriquement iedit dispositif à une alimentation électrique, ce connecteur ayant deux organes (44,46) complémentaires aux deux organes de connexion (4,6) dudit dispositif, ces deux organes complémentaires présentant respectivement deux parties (54,56) isolées électriquement ou formées d'un matériau isolant qui servent de butées exerçant respectivement une pression sur lesdits deux éléments (14,16) élastiquement déformables ou élastiquement déplaçables lors de l'assemblage dudit connecteur avec ledit dispositif, de manière à comprimer ou déplacer ces deux éléments et à les maintenir séparés des deux organes de connexion dudit dispositif une fois ce dispositif et le connecteur assemblés.

6. Ensemble selon la revendication 5, **caractérisé en ce que** les deux organes complémentaires (44,46) dudit connecteur présentent des parties (50,51) élastiquement déformables ou élastiquement déplaçables agencées pour exercer une pression latérale sur les deux organes de connexion dudit dispositif de manière à assurer un bon contact électrique avec les deux organes de connexion de ce dispositif et à maintenir ce dernier et ledit connecteur assemblés une fois qu'un assemblage a été effectué.

## Patentansprüche

1. Vorrichtung (1), die mit wenigstens einer Laserdiode (2) und zwei Organen (4, 6) für einen elektrischen Anschluß an eine elektrische Versorgung (8) zum Versorgen der wenigstens einen Laserdiode versehen ist, **dadurch gekennzeichnet, daß** sie zwei elastisch verformbare oder verschiebbare Elemente (14, 16) umfaßt, die elektrische Leiter sind und in einem Teil (10) der Vorrichtung angeordnet sind, die von den beiden Anschlußorganen elektrisch isoliert sind, wobei diese beiden elastisch verformbaren oder verschiebbaren Elemente elektrisch verbunden und in der Weise angeordnet sind, daß sie sich an zwei entsprechenden Kontaktoberflächen (34, 36) der beiden Anschlußorgane abstützen, wenn die Vorrichtung nicht mittels eines die beiden elektrischen Anschlußorgane ergänzenden äußeren Verbinders (40) mit der Versorgung verbunden ist, wobei die beiden elastisch verformbaren oder verschiebbaren Elemente bei der Einführung dieses äußeren Verbinders von dem einen bzw. dem anderen der beiden Anschlußorgane getrennt sind oder nach der Einführung dieses äußeren Verbinders von dem einen bzw. dem anderen der beiden Anschlußorgane getrennt werden können.

2. Vorrichtung nach Anspruch 1, **dadurch gekennzeichnet, daß** die beiden elastisch verformbaren oder verschiebbaren Elemente (14, 16) durch die Wirkung eines Drucks in Einführungsrichtung des äußeren Verbinders (40) elastisch verformbar oder elastisch verschiebbar sind, wobei diese beiden Elemente zwei entsprechende Abstützflächen (26, 28) aufweisen, an denen sich zwei entsprechende Teile des äußeren Verbinders abstützen können, wenn er eingeführt wird, um die beiden Anschlußorgane von den beiden elastisch verformbaren oder elastisch verschiebbaren Elementen elektrisch zu trennen.

3. Vorrichtung nach Anspruch 2, **dadurch gekennzeichnet, daß** jedes der beiden elastisch verformbaren oder elastisch verschiebbaren Elemente (14, 16) durch einen Stift oder einen Höcker gebildet ist, dem eine Feder oder ein Block aus einem komprimierbaren Material zugeordnet ist, die bzw. der eine elastische Verschiebung jedes dieser beiden Elemente in Einführungsrichtung ermöglicht.

4. Vorrichtung nach Anspruch 2 oder 3, **dadurch gekennzeichnet, daß** jedes der beiden Anschlußorgane (4, 6) L-Form besitzt, wobei sich die beiden Kontaktflächen (34, 36) in den entsprechenden Bereichen der beiden Knicke (30, 32) befinden, die diese beiden Organe aufweisen.

5. Einheit, die eine Vorrichtung (1) nach einem der Ansprüche 2 bis 4 und einen von dieser Vorrichtung verschiedenen Verbinder (40), der dazu dient, die Vorrichtung an eine elektrische Versorgung elektrisch anzuschließen, umfaßt, wobei dieser Verbinder zwei die beiden Anschlußorgane (4, 6) der Vorrichtung ergänzende Organe (44, 46) besitzt, wobei diese beiden ergänzenden Organe jeweils zwei elektrisch isolierte oder aus einem isolierenden Werkstoff gebildete Teile (54, 56) aufweisen, die als Anschläge dienen, die auf die beiden elastisch verformbaren oder elastisch verschiebbaren Elemente (14, 16) einen Druck ausüben, wenn der Verbinder mit der Vorrichtung zusammengefügt wird, derart, daß diese beiden Elemente komprimiert oder verschoben werden und die beiden Anschlußorgane der Vorrichtung getrennt gehalten werden, sobald die Vorrichtung und der Verbinder zusammengefügt worden sind.

6. Einheit nach Anspruch 5, **dadurch gekennzeichnet, daß** die beiden ergänzenden Organe (44, 46) des Verbinders elastisch verformbare oder elastisch verschiebbare Teile (50, 51) aufweisen, die so beschaffen sind, daß sie auf die beiden Anschlußorgane der Vorrichtung einen seitlichen Druck ausüben, derart, daß ein guter elektrischer Kontakt mit den beiden Anschlußorganen dieser Vorrichtung gewährleistet ist und diese letztere und der Verbinder zusammengefügt gehalten werden, sobald eine Zusammenfügung erfolgt ist.

## Claims

1. Device (1) provided with at least one laser diode (2) and two electric connecting members (4, 6) for connection to an electric power supply (8) for supplying said at least one laser diode, **characterized in that** it includes two elements (14, 16) which can be elastically deformed or moved, which are conductive electrically and arranged in a portion (10) of the device electrically insulated from the connecting members, these two elastically deformable or moveable elements being electrically connected and arranged so as to abut against two respective contact surfaces (34, 36) of the two connecting members when the device is not connected to said power supply by means of an external connector (40) which is complementary to the two electric connecting members, said two elastically deformable or moveable elements being respectively separated from the two connecting members when the external connector connected to said power supply is introduced or are able to be respectively separated from said two connecting members after the external connector is introduced.

2. Device according to claim 1, **characterized in that** said two elastically deformable or moveable elements (14, 16) are able to be elastically deformed or elastically moved via the action of pressure along a direction of introduction of said external connector (40), these two elements respectively having two support surfaces (26, 28) against which two portions of the external connector can abut when the latter is introduced in order to separate electrically said two connecting members of the two elastically deformable or moveable elements.

3. Device according to claim 2, **characterized in that** each of said two elastically deformable or moveable elements (14, 16) is formed by a pin or contact stud associated with a spring or block of compressible material allowing an elastic movement of each of these two elements along said direction of introduction.

4. Device according to claim 2 or 3, **characterized in that** each of the two connecting members (4, 6) is L shaped, said two contact surfaces (34, 36) being situated respectively in the regions of two bends (30, 32) borne respectively by said two members.

5. Assembly including a device (1) according to any of claims 2 to 4 and a connector (40) distinct from said device which is used to connect said device electrically to an electric power supply, said connector having two members (44, 46) complementary to the two connecting members (4, 6) of said device, these two complementary members respectively having two electrically insulated portions (54, 56) or formed of an electrically insulating material which act as stops respectively exerting a pressure on said two elastically deformable or moveable elements (14, 16) when said connector is assembled with said device, so as to compress or move these two elements and to keep them separate from the two connecting members of said device once the device and the connector are assembled.

6. Assembly according to claim 5, **characterized in that** the two complementary members (44, 46) of said connector have elastically deformable or elastically moveable portions (50, 51) arranged to exert a lateral pressure on the two connecting members of said device so as to assure a good electric contact with the two connecting members of said device and to keep the latter and said connector assembled once they have been assembled.
